Europäisches Patentamt

European Patent Office

Office européen des brevets

(19)

(11) Veröffentlichungsnummer : **0 086 483**
**B1**

(12) # EUROPÄISCHE PATENTSCHRIFT

(45) Veröffentlichungstag der Patentschrift :
**30.12.86**

(21) Anmeldenummer : **83101403.0**

(22) Anmeldetag : **14.02.83**

(51) Int. Cl.⁴ : **H 01 L 25/12,** H 01 L 23/40,
H 02 M   1/00

(54) **Leistungsgleichrichteranordnung.**

(30) Priorität : **17.02.82 DE 3205650**

(43) Veröffentlichungstag der Anmeldung :
**24.08.83 Patentblatt 83/34**

(45) Bekanntmachung des Hinweises auf die Patenterteilung : **30.12.86 Patentblatt 86/52**

(84) Benannte Vertragsstaaten :
**AT CH FR GB LI NL**

(56) Entgegenhaltungen :
**CH-A-   394 375**
**US-A- 3 237 079**

(73) Patentinhaber : **Siemens Aktiengesellschaft Berlin
und München**
**Wittelsbacherplatz 2**
**D-8000 München 2 (DE)**

(72) Erfinder : **Koroncai, Adam Istvan, Dipl.-Ing.
Wehrweg 1**
**A-9020 Klagenfurt (DE)**
Erfinder : **Pötsch, Edmund Reinfried**
**Augsburger Strasse 41**
**D-8901 Königsbrunn (DE)**

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

EP 0 086 483 B1

## Beschreibung

Die Erfindung betrifft eine Leistungsgleichrichteranordnung, bestehend aus einem Übertrager, aus mindestens einem Kühlkörper und aus mindestens einem Leistungsgleichrichter, welcher am Gehäuseboden einen Anschluß aufweist.

Bekanntlich kann ein Leistungsgleichrichter ein Halbleiterelement und konstruktive Teile wie Stromzuführungen, eine gegen mechanische und athmosphärische Einflüsse schützende Kapsel, sowie einen metallischen Gehäuseboden mit einer Kontaktfläche und beispielsweise einem Gewindezapfen zum Befestigen des Leistungsgleichrichters am Kühlkörper, aufweisen. Die Eingänge des Leistungsgleichrichters können als Anschlußfahnen, welche an der Oberseite der Kapsel befestigt sind, ausgebildet sein. Der Gewindezapfen und Gehäuseboden können als Ausgang dienen. Der Gewindezapfen kann zusammen mit der ihn umschließenden ebenen Ringfläche des Gehäusebodens etwa zu gleichen Teilen die Abführung der im Leistungsgleichrichter entstehenden Verlustwärme übernehmen.

Falls die Eingänge des Leistungsgleichrichters mit einem Übertrager verbunden sind, welcher Verlustwärme erzeugt, wird die Verlustwärme auf die Anschlußfahnen des Leistungsgleichrichers abgeführt. Die Verlustwärme des Übertragers wird also über den Leistungsgleichrichter auf den Kühlkörper abgeführt. Die beiden Wärmequellen, Übertrager und Leistungsgleichrichter, sind also in Reihe geschaltet. Das kann zu einer unerwünschten Überhitzung des Übertragers und des Leistungsgleichrichters führen.

Der Erfindung lag daher die Aufgabe zugrunde, eine Leistungsgleichrichteranordnung der oben angegebenen Art anzugeben, welche eine Überhitzung des Übertragers und des Leistungsgleichrichters verhindert.

Diese Aufgabe wird dadurch gelöst, daß der Anschluß am Gehäuseboden zugleich als Anschluß für die Sekundärwicklung des Übertragers dient, daß die Sekundärwicklung des Übertragers als Band ausgebildet ist, und daß der Leistungsgleichrichter als Befestigungselement dient, welches am Kühlkörper verschraubt ist, und mit welchem das Ende des Bandes zwischen dem Gehäuseboden und dem Kühlkörper eingeklemmt ist.

Der Leistungsgleichrichter weist vorteilhafterweise am Gehäuseboden einen Gewindezapfen zum Verschrauben mit dem Kühlkörper auf. In einer vorteilhaften Ausführungsform der Erfindung sind mindestens zwei Leistungsgleichrichter parallel geschaltet, weist das Band eine der Anzahl der Leistungsgleichrichter entsprechende Anzahl von übereinanderliegenden, elektrisch leitenden ersten Schichten auf, ist jede der ersten Schichten jeweils mit einem der Leistungsgleichrichter verbunden, und ist jeweils zwischen zwei ersten Schichten eine elektrisch isolierende wärmeleitende zweite Schicht vorgesehen. Die Erfindung hat den Vorteil, daß die Verlustwärme des Übertragers, die aus Kern- und Kupferverlusten entstehen kann, direkt auf den Kühlkörper geleitet wird. Gleichzeitig wird dabei die elektrische Verbindung zum Leistungsgleichrichter hergestellt. Bei einer Vollauslastung des Leistungsgleichrichters wird dessen Verlustwärme nicht mehr an die Sekundärwicklung des Übertragers, sondern an den Kühlkörper abgegeben. Die Wärmequellen, Übertrager und Leistungsgleichrichter, sind also parallel geschaltet. Weiter ist vorteilhaft, daß ein Skineffekt vermieden wird, wodurch eine zusätzliche Wärmeentwicklung wegen einer zu hohen Stromdichte im Übertrager verhindert wird. Durch die Aufteilung des Bandes in unterschiedliche Schichten und die Verbindung jeweils einer elektrisch leitenden Schicht mit einem Leistungsgleichrichter wird jedes einzelne Band separat gleichgerichtet und dadurch eine Stromsymmetrie erreicht.

Im folgenden wird die Erfindung anhand eines vorteilhaften Ausführungsbeispiels weiter beschrieben.

Figur 1 zeigt eine Schaltungsanordnung,

Figur 2 zeigt schematisch eine Seitenansicht der Schaltungsanordnung gemäß Fig. 1,

Figur 3 zeigt eine Draufsicht der Schaltungsanordnung,

Figur 4 zeigt eine Ansicht einer weiteren Schaltungsanordnung,

Figur 5 zeigt ein elektrisches Ersatzschaltbild der Schaltungsanordnung gemäß Fig. 2 und 4 zur Darstellung des Wärmeflusses.

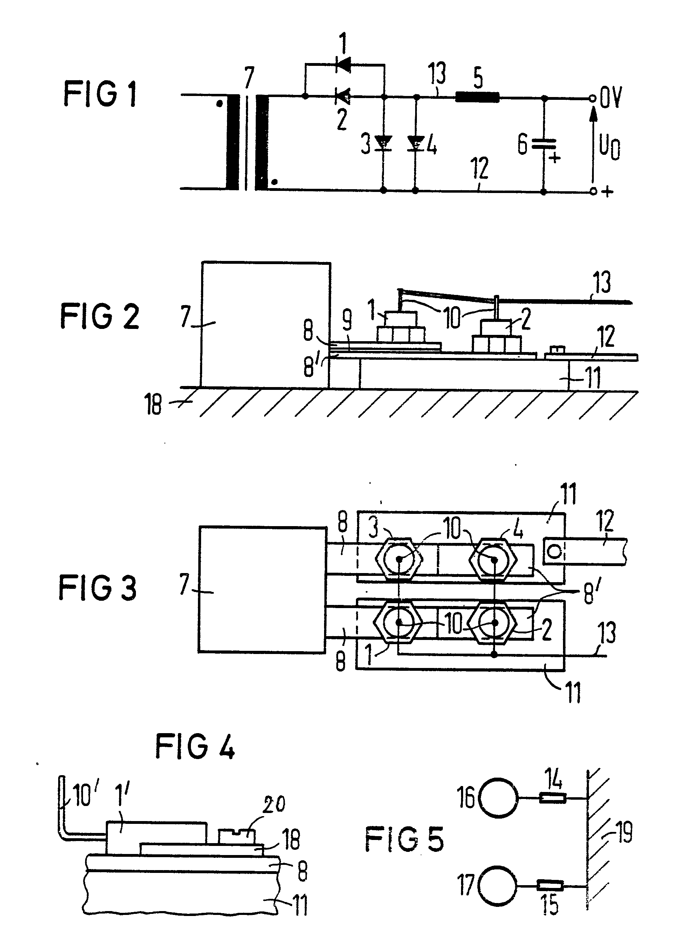

Die Leistungsgleichrichteranordnung in Figur 1 weist einen Übertrager 7, vier Leistungsgleichrichter 1, 2, 3, 4, eine induktive Last 5 und eine kapazitive Last 6 auf. Die Leistungsgleichrichter 1, 2, 3, 4 sind als Zweiwegschaltung an die Sekundärwicklung des Übertragers 7 angeschaltet, wobei jeweils zwei Leistungsgleichrichter 1, 2, und 3, 4 parallel zueinander geschaltet sind. Die Kathoden der Leistungsgleichrichter 1, 2, 3, 4 sind mit dem Übertrager 7 verbunden. Die Anoden aller Leistungsgleichrichter 1, 2, 3, 4 sind mit der Induktivität 5 verbunden. Die Kapazität 6 ist parallel zum Ausgang der Schaltung angeordnet. Der Verbindungspunkt der Induktivität 5 und der Kapazität 6 liegt auf null Volt.

Die Leistungsgleichrichter 1, 2, 3, 4 in Figur 2 und Figur 3 weisen ein gegen mechanische und athmosphärische Einflüsse schützendes Gehäuse mit einem Gehäuseboden auf, welcher mit einer ringförmigen Kontaktfläche und einem Gewindezapfen versehen ist. Je zwei Leistungsgleichrichter 1, 2, 3, 4 sind in zwei Kühlkörper 11 eingeschraubt. Die Kontaktfläche am Gehäuseboden und der Gewindezapfen dienen als Kathode. Als Anode sind auf der Oberseite der Gehäuse Anschlußfahnen 10 angebracht. Die Kühlkörper 11 und der Übertrager 7 sind auf einer gekühlten Bodenplatte 18 angeordnet. Die Sekundärwicklung des Übertragers 7 ist aus dem Übertrager herausgeführt. Die Wicklung besteht aus einem Band 8, 8', 9, welches aus zwei ersten Schichten 8, 8', welche elektrisch leitend sind, und aus einer zweiten Schicht 9, welche elektrisch isolierend und wärmeleitend ist, besteht. Ein derartiges Band ist beispielsweise unter dem Namen Kapton-Band bekannt.

Die Bänder 8, 8' sind jeweils zwischen den Gehäuseböden der Leistungsgleichrichter 1, 2, 3, 4 und den beiden Kühlkörpern 11 eingeklemmt. Dabei dienen die Leistungsgleichrichter 1, 2, 3, 4 als Befestigungselemente in der Art einer Schraube. Die Eingänge aller Leistungsgleichrichter 1, 2, 3, 4 sind somit umittelbar mit der Sekundärwicklung des Übertragers 7 verbunden. Die Verbindung der Anschlußfahne 10 mit der Induktivität 5 erfolgt über einen ersten Leiter 13. Die elektrisch leitende Verbindung von den Gewindezapfen zum Ausgang der Schaltungsanordnung erfolgt über den Kühlkörper 11 und einen weiteren Leiter 12, welcher mit dem Kühlkörper, in welchem die Leistungsgleichrichter 3, 4 eingeschraubt sind, elektrisch leitend verbunden ist.

Die Dicke der elektrisch leitenden Schichten 8, 8' hängt von der Eindringtiefe des Stromes ab. Sie ist so bemessen, daß ein Skineffekt verhindert wird. Jeweils eine elektrisch leitende Schicht 8, 8' ist mit jeweils einem der Leistungsgleichrichter 1, 2, 3, 4 verbunden. Das geschieht dadurch, daß Band 8, 8', 9 bei den Leistungsgleichrichtern 1, 3, die dem Übertrager 7 am nächsten sind, mitsamt allen Schichten 8, 8', 9 eingeklemmt wird. Auf diese Weise besteht eine elektrisch leitende Verbindung zwischen dem Übertrager 7 und den Leistungsgleichrichtern 1, 3 ausschließlich über die oberste Schicht 8. Die Abführung der Verlustwärme der Leistungsgleichrichter 1, 3 erfolgt jedoch über alle Schichten des Bandes 8, 8', 9 zum Kühlkörper 11. Ebenso wird ein großer Teil der Verlustwärme des Übertragers 7 über alle Schichten des Bandes 8, 8', 9 an den Kühlkörper abgeleitet. Zur Verbindung der weiteren Leistungsgleichrichter 2, 4 ist die obere elektrisch leitende Schicht 8 und die zweite Schicht 9 entfernt. Somit besteht eine elektrisch leitende Verbindung zwischen dem Übertrager 7 und den Leistungsgleichrichtern 2, 4 ausschließlich über die untere elektrisch leitende Schicht 8'. Die Ableitung der Verlustwärme erfolgt ebenfalls über diese Schicht 8'.

Figur 4 zeigt eine weitere beispielhafte Ansicht einer Schaltungsanordnung mit einem Leistungsgleichrichter 1'. Das Gehäuse des Leistungsgleichrichters 1' besteht aus einem Kunststoff, welcher um die Halbleiterelemente herum vergossen ist. Der Gehäuseboden des Leistungsgleichrichters 1' besteht teilweise aus einer Metallplatte 18, die als Eingangsanschluß dient. Der Leistungsgleichrichter 1' ist mit dem Kühlkörper 11 mittels einer Schraube 20 verschraubt, welche durch eine Öffnung in der Metallplatte 18 geführt ist. Zwischen dem Gehäuseboden und dem Kühlkörper 11 ist das Band 8 eingeklemmt. Die Anschlußfahnen 10' sind seitlich aus dem Gehäuse des Leistungsgleichrichters 1' herausgeführt.

Figur 5 zeigt eine Wärmequelle 16, die vom Übertrager 7 gebildet wird. Sie ist über einen thermischen Widerstand 14 mit einer Wärmesenke 19 verbunden. Eine Wärmequelle 17, die von den Leistungsgleichrichtern 1, 2, 3, 4 gebildet ist, ist über einen weiteren thermischen Widerstand 15 mit der Wärmesenke 19 verbunden. Die thermischen Widerstände 14, 15 sind somit parallel geschaltet. Sie werden jeweils nur mit den Wärmeflüssen belastet, die von den zugeordneten Wärmequellen 16 bzw. 17 zur Wärmesenke 19 fließen. Die in den thermischen Widerständen 14 und 15 entstehenden Wärmemengen entsprechen der Verlustwärme des Übertragers 7 bzw. der Leistungsgleichrichter 1, 2, 3, 4. Figur 5 stellt ein elektrisches Ersatzschaltbild zur Darstellung des Wärmeflusses dar.

## Patentansprüche

1. Leistungsgleichrichteranordnung, bestehend aus einem Übertrager (7), aus einem Kühlkörper (11) und aus mindestens einem Leistungsgleichrichter (1, 2, 3, 4), welcher am Gehäuseboden einen Anschluß aufweist, dadurch gekennzeichnet, daß der Anschluß am Gehäuseboden zugleich als Anschluß für die Sekundärwicklung des Übertragers (7) dient, daß die Sekundärwicklung des Übertragers (7) als Band (8, 8', 9) ausgebildet ist, und daß der Leistungsgleichrichter (1, 2, 3, 4) als Befestigungselement dient, welches am Kühlkörper (11) verschraubt ist, und mit welchem das Ende des Bandes (8, 8', 9) zwischen dem Gehäuseboden und dem Kühlkörper eingeklemmt, ist.

2. Leistungsgleichrichteranordnung nach Anspruch 1, dadurch gekennzeichnet, daß der Leistungsgleichrichter am Gehäuseboden einen Gewindezapfen zum Verschrauben mit dem Kühlkörper (11) aufweist.

3. Leistungsgleichrichteranordnung nach Anspruch 1, dadurch gekennzeichnet, daß mindestens zwei Leistungsgleichrichter (1, 2, 3, 4) parallel geschaltet sind, daß das Band (8, 8', 9) eine der Anzahl der Leistungsgleichrichter (1, 2, 3, 4) entsprechende Anzahl von übereinanderliegenden elektrisch leitenden ersten Schichten (8, 8') aufweist, daß jede der ersten Schichten jeweils mit einem Leistungsgleichrichter (1, 2, 3, 4) verbunden ist, und daß jeweils zwischen zwei ersten Schichten (8, 8') eine elektrisch isolierende und wärmeleitende zweite Schicht (9) vorgesehen ist.

4. Leistungsgleichrichteranordnung nach Anspruch 2, dadurch gekennzeichnet, daß die Dicke der ersten Schichten (8, 8') von der Eindringtiefe des durchfließenden Stromes abhängt, so daß ein Skineffekt vermieden wird.

## Claims

1. A power rectifier arrangement consisting of a transformer (7), a heat sink (11) and at least one power rectifier (1, 2, 3, 4) which has a terminal at the base of the housing, characterised in that the terminal at the base of the housing simultaneously serves as terminal for the secondary winding of the transformer (7) ; that the secondary winding of the transformer (7) is in the form of a strip (8, 8', 9) ; and that the power rectifier (1, 2, 3, 4) serves as a fastening element which is screwed to the heat sink (11) and by means of which the end of the strip (8, 8', 9) is clamped between the base of the housing and the heat sink.

2. A power rectifier arrangement as claimed in Claim 1, characterised in that at the base of the housing, the power rectifier has a threaded pin for screwing to the heat sink (11).

3. A power rectifier arrangement as claimed in Claim 1, characterised in that at least two power rectifiers (1, 2, 3, 4) are connected in parallel ; that the strip (8, 8', 9) has a number of superposed electrically-conductive first layers (8, 8'), which corresponds to the number of power rectifiers (1, 2, 3, 4) ; that each of the first layers is respectively connected to a power rectifier (1, 2, 3, 4) ; and that an electrically-insulating and heat-conducting second layer (9) is arranged in each case between two first layers (8, 8').

4. A power rectifier arrangement as claimed in Claim 2, characterised in that the thickness of the first layers (8, 8') is dependent upon the depth of penetration of the current flowing therethrough, so that a skin effect is avoided.

**Revendications**

1. Dispositif redresseur de puissance, constitué par un transformateur (7), par un dissipateur de chaleur (11) et par au moins un redresseur de puissance (1, 2, 3, 4) qui comporte sur le fond du boîtier une borne de raccordement, caractérisé par le fait que la borne de raccordement prévue sur le fond du boîtier sert en même temps de borne de raccordement pour l'enroulement secondaire du transformateur (7), que l'enroulement secondaire du transformateur (7) est réalisé sous la forme d'une bande (8, 8', 9), et que le redresseur de puissance (1, 2, 3, 4) sert d'élément de fixation qui est vissé sur le dissipateur de chaleur (11), et avec lequel l'extrémité de la bande (8, 8', 9) est serrée entre le fond du boîtier et le dissipateur de chaleur.

2. Dispositif redresseur de puissance selon la revendication 1, caractérisé par le fait que le redresseur de puissance comporte, sur le fond du boîtier, une cheville filetée pour le vissage avec le dissipateur de chaleur (11).

3. Dispositif redresseur de puissance selon la revendication 1, caractérisé par le fait qu'au moins deux redresseurs de puissance (1, 2, 3, 4) sont montés en parallèles, que le ruban (8, 8', 9) comporte un nombre de premières couches électriquement conductrices superposées (8, 8'), qui correspond au nombre de redresseurs de puissance (1, 2, 3, 4), que chacune des premières couches est reliée à un redresseur de puissance (1, 2, 3, 4), et qu'entre deux premières couches (8, 8') est prévue une seconde couche (9) qui est électriquement isolante et qui est thermoconductrice.

4. Dispositif redresseur de puissance selon la revendication 2, caractérisé par le fait que l'épaisseur des premières couches (8, 8') dépend de la profondeur de pénétration du courant qui passe, en sorte que l'on évite un effet de peau.

0 086 483

FIG 1

FIG 2

FIG 3

FIG 4

FIG 5

1